## Europäisches Patentamt
## European Patent Office
## Office européen des brevets

(19)

(11) Numéro de publication: **0 102 290**
**B1**

(12)

# FASCICULE DE BREVET EUROPEEN

(45) Date de publication du fascicule du brevet:
**06.08.86**

(51) Int. Cl.⁴: **H 03 C 1/28**

(21) Numéro de dépôt: **83401652.9**

(22) Date de dépôt: **11.08.83**

(54) **Dispositif modulateur pour tube hyperfréquence.**

(30) Priorité: **20.08.82 FR 8214437**

(43) Date de publication de la demande:
**07.03.84 Bulletin 84/10**

(45) Mention de la délivrance du brevet:
**06.08.86 Bulletin 86/32**

(84) Etats contractants désignés:
**BE DE FR GB IT NL**

(56) Documents cités:
**US - A - 3 339 146**
**US - A - 3 414 825**
**US - A - 3 806 836**

**MICROWAVE JOURNAL, vol. 23, no. 8, août 1980, pages 57-70, Dedham US, G.W. EWELL et al.: "High power millimeter-wave radar transmitters"**
**1965 IEEE INTERNATIONAL CONVENTION RECORD, vol. 13, no. 4, 22-26 mars 1965, pages 201-207, New York, US, L.L. FISHER et al.: "Design of a hybrid floating deck modulator for 150 KV pulse generation"**
**1979 IEEE MTT-S INTERNATIONAL MICROWAVE SYMPOSIUM DIGEST, 1979, pages 450-452, New York, US, G.W. EWELL et al.: "Operation of pulsed millimeter wavelength extended interaction oscillators"**

(73) Titulaire: **THOMSON-CSF, 173, Boulevard Haussmann, F-75379 Paris Cedex 08 (FR)**

(72) Inventeur: **Desaintfuscien, Jean-Pierre, THOMSON-CSF SCPI 173, bld Haussmann, F-75379 Parix Cedex 08 (FR)**

(74) Mandataire: **Benoit, Monique et al, THOMSON-CSF SCPI 19, avenue de Messine, F-75008 Paris (FR)**

**Description**

La présente invention concerne un émetteur hyperfréquence du type à modulation.

Le domaine principal d'application d'un dispositif modulateur pour émetteur hyperfréquence objet de la présente demande est un émetteur radar utilisant un tube fonctionnant en hyperfréquence dans lequel un commutateur de modulation, général un tube, déclenche le tube émetteur délivrant un impulsion à haute énergie. Cet émetteur très généralement require deux tensions d'alimentation indépendantes; c'est un émetteur connu sous ses initiales anglo-saxonnes EIO (Extended Interaction Oscillator) et les valeurs de ces tensions sont très élevées.

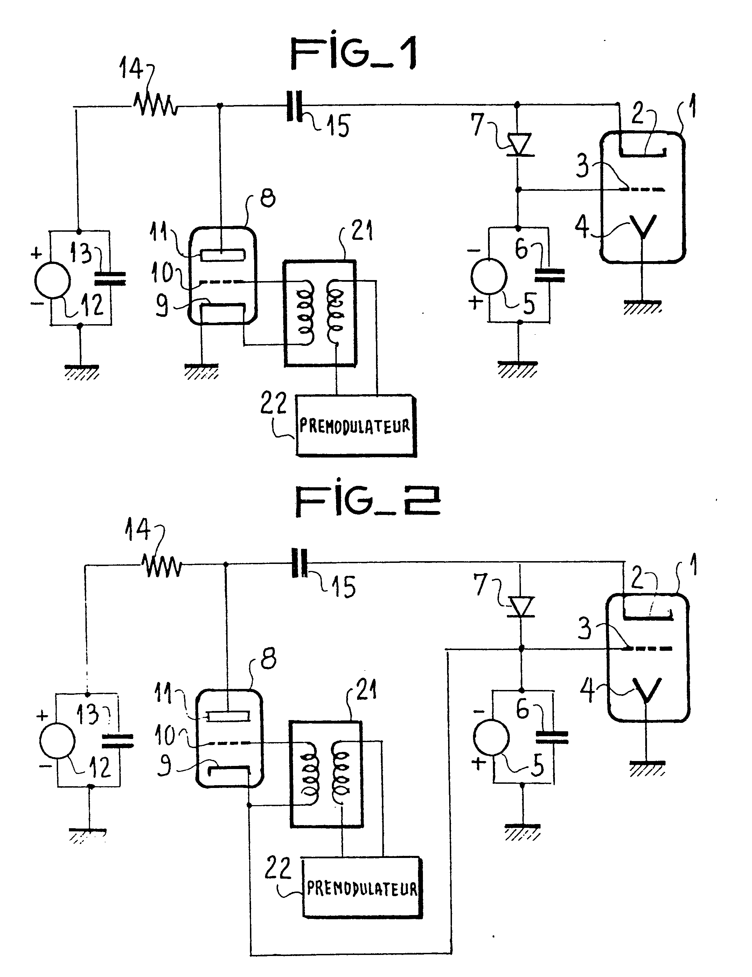

La fig. 1 présente de façon très schématique e montage classique, d'un émetteur hyperfréquence du type à modulation par la cathode. Un tel montage est décrit par exemple dans l'article de George W. Ewell, intitulé: «High Power Millimeter-Wave Radar Transmitters» et publié dans la revue «Microwave Journal», volume 23, numéro 8, août 1980, pages 57–70.

Le tube d'émission 1 est un tube EIO comportant une cathode 2, une anode 3 et un collecteur 4 connecté à la masse. Une première source d'alimentation 5 avec une capacité 6 de filtrage connectée entre ses bornes, alimente l'anode 3 du tube 1 et est connectée à la cathode 2 du tube à travers une diode 7. Le commutateur de modulation est un tube 8 avec une cathode 9; une grille 10 alimentée à partir d'un prémodulateur 22 à travers un transformateur d'impulsion 21 et une anode 11 connectée à une seconde source d'alimentation 12 avec une capacité de filtrage 13 à ses bornes. Une résistance 14 et une capacité réservoir 15 sont disposées dans la liaison connectant le commutateur 8 au tube émetteur 1. Les valeurs des tensions des sources 5 et 12 sont très différentes et dépendent du tube hyperfréquence utilisé. A titre d'exemple, on considère un tube dans lequel ces tensions varient du simple au double, la valeur de la tension de la source 5 étant de l'ordre de +8KV et celle de la source 12 de l'ordre de +16 KV.

En régime statique, dans l'exemple considéré il y a en permanence une valeur de potentiel de −8 KV sur l'anode du tube émetteur 1 par rapport à son collecteur 4; la cathode 2 du tube 1 est également portée à ce potentiel de −8 KV à travers la diode 7. La capacité réservoir 15 est chargée à 24 KV par les deux sources de tension 12 et 5 qui sont montées en série à travers elle.

En régime dynamique, au moment de l'émission, la cathode 2 du tube émetteur 1, qui était portée au même potentiel que l'anode, doit être portée à une nouvelle valeur de potentiel, négative par rapport à cette électrode. Cette valeur est de −16 KV par raport à l'anode 3 et donc de −24 KV par rapport au collecteur 4. Ainsi au moment de l'émission déclenchée par le tube 8, celui-ci conduit et transmet un front négativ de 16 KV sur l'anode de la diode 7, portant le potentiel de la cathode 2 du tube 1 à −16 KV par rapport à son anode 3 et donc à −24 KV par rapport à son collecteur 4.

Ainsi donc dans ce montage de l'art antérieur, l'une des sources de tension, la source 5 en l'occurrence fournit la différence de potentiel entre l'anode 3 et le collecteur 4 nécessaire au tube émetteur 1 tandis que la seconde source 12 de tension doit fournir une valeur de tension égale à la différence de potentiel nécessaire entre l'anode 3 et la cathode 2 du tube au moment de l'émission.

On constate dans ces conditions que les valeurs des tensions mises en jeu sont très élevées, entraînant un volume des composants, comme la capacité réservoir 15 ou les bobinages des transformateurs haute tension par exemple, également important.

Le but de l'invention est de définir un montage qui permette de réduire ces inconvénients, c'est-à-dire de travailler avec des valeurs de tension plus faibles entraînant une réduction du volume des composants et augmentant la fiabilité du matériel.

La présente invention a pour objet un émetteur hyperfréquence du type à modulation, comportant un tube d'émission, un tube commutateur de modulation, un condensateur, connecté entre l'anode du tube commutateur de modulation et la cathode du tube d'émission et une diode dont l'anode est connectée à la cathode du tube d'émission, la cathode de la diode étant connectée à l'anode du tube d'emission, le tube d'émission étant polarisé, en régime statique par une première source, dont la borne positive est connectée à la masse et la borne négative à l'anode du tube d'émission, destinée à porter son anode et sa cathode à un même potentiel par rapport à son collecteur, le tube commutateur de modulation étant alors bloqué, et un régime dynamique par la décharge, à travers le tube commutateur de modulation rendu alors passant, du condensateur préalablement chargé, en régime statique, par la première source et par une deuxième source dont la borne négative est reliée à la masse et la borne positive à l'anode du tube commutateur de modulation, afin de porter alors son anode à un potentiel relativ par rapport à sa cathode, caractérisé en ce que la cathode du tube commutateur de modulation est directement connectée à l'anode du tube d'émission.

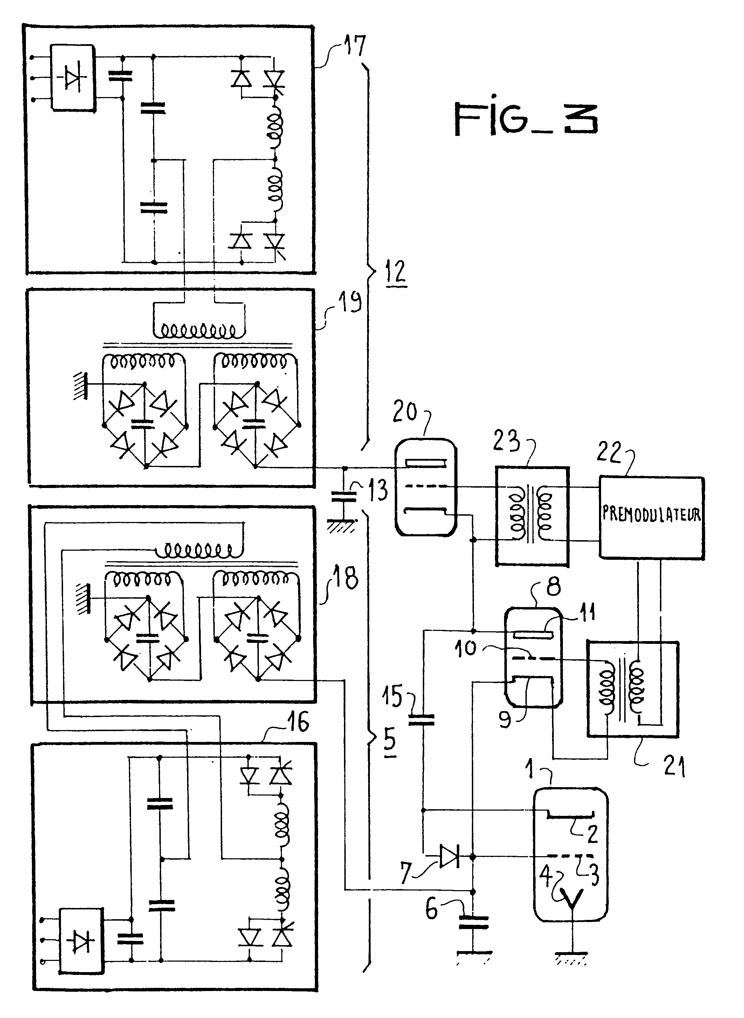

D'autres caractéristiques et avantages de l'invention apparaîtront dans la description qui suit d'un exemple de réalisation donné à l'aide des fig. 2 et 3, la fig. 1 étant relative à l'art antérieur, la fig. 2 représentant de façon schématique le montage de l'émetteur du type à modulation par sa cathode suivant l'invention et la fig. 3 représentant un schéma plus détaillé du commutateur de modulation selon l'invention.

On a constaté dans l'étude de l'art antérieur que le montage du tube émetteur hyperfréquence et du tube constituant le commutateur chargé de déclencher l'émission, requérait deux sources de tension de haute valeur, l'une d'entre elles étant beaucoup plus élevée que l'autre, le double pour le type du tube utilisé, ce qui entraînait un volume important des composants, en particulier de la capacité réservoir.

La fig. 2 représente de façon schématique le montage du tube d'émission, à modulation par la cathode, suivant l'invention. Le schéma de la fig. 2 utilisant les mêmes composants que celui de la fig. 1, les références des éléments communs aux deux schémas sont les mêmes. Le montage du commutateur de la fig. 2 est toutefois différent de celui de la fig. 1. Alors que suivant l'art antérieur, la cathode 9 du tube commutateur 8 était connectée à la masse, suivant l'invention, cette cathode est connectée directement à l'anode 3 du tube émetteur 1.

Le fonctionnement du dispositif est le suivant. La capacité réservoir 15 est toujours chargée au potentiel, somme des valeurs absolues des tensions fournies par deux sources 5 et 12 montées en série. Toutefois, la valeur de la tension de la source 12 est plus faible dans le montage suivant l'invention que dans le montage suivant l'art antérieur. Cette valeur est réduite pouvant atteindre dans l'exemple considéré la moitié de la valeur qu'elle avait soit 8 KV. La capacité réservoir 15 ne se charge alors plus qu'à 16 KV. Cette diminution de la tension fournie par une des sources découle de la caractéristique de montage suivant l'invention. En effet, pendant l'émission, c'est-à-dire lorsque le tube 1 est déclenché, la tension de la capacité réservoir n'est plus appliquée entre la cathode 2 et le collecteur 4 du tube 1, mais simplement entre la cathode 2 et l'anode 3. On remarque alors que l'anode 3 du tube 1 est portée en permanence à la tension de la source d'alimentation 5 soit −8 KV, par rapport au collecteur 4.

Pendant l'émission, suivant les conditions de fonctionnement requises pour le tube hyperfréquence 1, la cathode 2 dudit tube doit présenter un potentiel égal à −16 KV par rapport à son anode et un potentiel égal à −24 KV par rapport à son collecteur C.

L'anode 2 du tube étant, par l'effet du montage suivant l'émission, portée en permanence, comme cela a été dit, au potentiel de la source 5, c'est-à-dire que la tension entre l'anode et le collecteur est égale à −8 KV, la capacité réservoir 15, n'a plus qu'à fournir une tension égale à la différence de la tension cathode-collecteur et de la tension anode-collecteur, soit (24−8) KV = 16 KV au tube émetteur 1. La capacité réservoir étant chargée à une valeur de tension somme des valeurs absolues des tensions des deux sources, 5 et 12, et la source 5 présentant une valeur de tension de 8 KV, la source 12 fournira également une tension égale à 8 KV.

D'une façon plus générale alors que la source 5 d'alimentation en tension anode-collecteur du tube d'émission 1 ne change pas, restant la même que suivant l'art antérieur pour le tube considéré, la source 12 n'a plus à fournir qu'une valeur de différence de potentiel égale à la différence entre la tension anode-cathode du tube émetteur et la tension anode-collecteur de ce même tube. Il est manifeste dans ces conditions que la tension nominale de la source 12 peut-être beaucoup plus faible que la valeur qu'elle doit avoir dans le montage suivant l'art antérieur. On a vu dans les explications précédentes que cette tension passait de la valeur 16 KV à la valeur 8 KV.

Pour un tube émetteur du même type mais dont les conditions de fonctionnement sont différentes, par exemple, une tension anode collecteur de 10 KV qui ne change pas d'un montage à l'autre et une tension cathode-collecteur de 22 KV avec une source de 10 KV, la source 12 n'aurait à fournir qu'une valeur de tension de 2 KV, au lieu de 12 KV.

Ainsi, les conditions de fonctionnement de tube émetteur 1 restant toujours les mêmes, le montage du commutateur de modulation 8 effectué suivant l'invention, permet de réduire la valeur totale des tensions d'alimentation nécessaires. La source d'alimentation 5 devant conserver sa valeur nominale, la source 12 contribuant à la charge de la capacité réservoir 15, peut être d'une valeur nettement inférieure à celle qu'elle présente dans le montage de l'art antérieur.

La fig. 3 représente un schéma plus détaillé du commutateur de modulation suivant l'invention dans lequel on a fait figurer les alimentations. Celles-ci sont repérées par les références 16 et 17. Ce sont des alimentations à découpage qui chargent les capacités de filtrage 6 et 13, par l'intermédiaire des transformateurs haute tension, 18 et 19. La lampe triode 20 remplace avantageusement la résistance 14 du schéma de la fig. 2; elle est mise au «cut-off» pendant l'émission et, conduisant dès la fin de l'émission décharge rapidement la capacité parasite entre la cathode 2 et l'anode 3 du tube modulateur. La grille de cette triode est alimentée à partir du prémodulateur 22 à travers un transformateur d'impulsion 23.

On peut noter un certain nombre d'avantages apportés par le montage suivant l'invention, avantages liés directement au fait que l'une des sources 12, présente une valeur de tension réduite par rapport à celle de l'art antérieur. Dans un des exemples de tube considéré, cette valeur réduite de tension est égale à la valeur de tension de l'autre source 5, de valeur inférieure. Visibles fig. 3 les transformateurs haute tension 18 et 19 ainsi que les capacités de filtrage 6 et 13 sont d'un volume plus réduit. Il en est de même de la capacité réservoir 15 qui, suivant l'invention, dans l'exemple numérique considéré se charge à 16 KV au lieu de 24 KV.

Les pertes d'énergie dues aux capacités réparties dans les bobinages des transformateurs haute tension 18 et 19 sont réduites. Enfin les tensions mises en jeu étant plus basses on peut également mentionner comme avantage supplémentaire, une meilleure fiabilité du matériel.

On a ainsi décrit un émetteur hyperfréquence du type à modulation par la cathode.

**Revendications**

1. Emetteur hyperfréquence du type à modulation, comportant un tube d'émission (1), un tube commutateur de modulation (8), un condensateur (15), connecté entre l'anode (11) du tube commutateur de modulation (8) et la cathode (2) du tube d'émission (1) et une diode (7) dont l'anode est connectée à la cathode (2) du tube d'émission (1), la cathode de la diode (7) étant connectée à l'anode (3) du tube d'émission, le tube d'émission étant polarisé, en régime statique par une première source (5) dont la borne positive est connectée à la masse et la borne négative à l'anode (3) du tube d'émission (1), destinée à porter son anode (3) et sa cathode (2) à un même potentiel par rapport à son collecteur (4), le tube commutateur de modulation étant alors bloqué, et en régime dynamique par la décharge, à travers le tube commutateur de modulation rendu alors passant, du condensateur (15) préalablement chargé, en régime statique, par la première source (5) et par une deuxième source (12) dont la borne négative est reliée à la masse et la borne positive à l'anode (11) du tube commutateur de modulation (8), afin de porter alors son anode à un potentiel relatif par rapport à sa cathode, caractérisé en ce que la cathode (9) du tube commutateur de modulation est directement connectée à l'anode (3) du tube d'émission.

2. Emetteur hyperfréquence suivant la revendication 1, caractérisé en ce qu'un tube triode (20) isole l'alimentation pendant la conduction du tube commutateur de modulation (8) et fait ensuite se décharger rapidement la capacité parasite cathode-anode du tube d'émission (1).

## Patentansprüche

1. Mit Modulation arbeitender Mikrowellensender, mit einer Senderöhre (1), einer Modulations-Schaltröhre (8), einem zwischen die Anode (11) der Modulations-Schaltröhre (8) und die Kathode (2) der Senderöhre (1) geschalteten Kondensator (15) und einer Diode (7), deren Anode mit der Kathode (2) der Senderöhre (1) verbunden ist, während die Kathode der Diode (7) mit der Anode (3) der Senderöhre verbunden ist, wobei die Senderöhre im statischen Betriebszustand durch eine erste Quelle (5) vorgespannt ist, deren positiver Anschluss mit Masse und deren negativer Anschluss mit der Anode (3) der Senderöhre (1) verbunden ist, um ihre Anode (3) und ihre Kathode (2) auf dasselbe Potential bezüglich ihres Kollektors (4) zu bringen, wobei die Modulations-Schaltröhre dann gesperrt ist, und im dynamischen Betriebszustand vorgespannt ist durch die über die dann stromführend gemachte Modulations-Schaltröhre erfolgende Entladung des Kondensators (15), der zuvor im statischen Betriebszustand durch die erste Quelle (5) aufgeladen wurde, und durch eine zweite Quelle (12), deren negativer Anschluss mit Masse und deren positiver Anschluss mit der Anode (11) der Modulations-Schaltröhre (8) verbunden ist, um dann ihre Anode auf ein Potential zu bringen, das auf ihre Kathode bezogen ist, dadurch gekennzeichnet, dass die Kathode (9) der Modulations-Schaltröhre direkt mit der Anode (3) der Senderöhre verbunden ist.

2. Mikrowellensender nach Anspruch 1, dadurch gekennzeichnet, dass eine Triodenröhre (20) die Versorgung während des stromführenden Zustandes der Modulations-Schaltröhre (8) abtrennt und anschliessend die schnelle Entladung der Kathoden-Anoden-Störkapazität der Senderöhre (1) verursacht.

## Claims

1. A modulation type microwave transmitter, comprising a transmitter tube (1), a modulation switching tube (8), a capacitor (15) conncted between the anode (11) of the modulation switching tube (8) and the cathode (2) of the transmitter tube (1) and a diode (7) the anode of which is connected to the cathode (2) of the transmitter tube (1), the cathode of the diode (7) being connected to the anode (3) of the transmitter tube, the transmitter tube being polarised in the static mode by a first source (5) the positive terminal of which is connected to ground and the negative terminal to the anode (3) of the transmitter tube (1), for connecting its anode (3) and its cathode (2) to the same potential with respect to its collector (4), the modulation switching tube then being blocked, and in the dynamic mode by the discharge, through the modulation switching tube then rendered conductive, of the capacitor (15) previously charged in the static mode by the first source (5), and by a second source (15) the negative terminal of which is connected to ground and the positive to the anode (11) of the modulation switching tube (8), in order to connect its anode to a potential relative to its cathode, characterized in that the cathode (9) of the modulation switching tube is directly connected to the anode (3) of the transmitter tube.

2. Microwave transmitter according to claim 1, characterized in that a triode tube (20) insulates the supply during the conduction of the modulation switching tube (8) and then causes the rapid discharge of the parasitic cathode-anode capacity of the transmitter tube (1).

0102290

## FIG_1

PREMODULATEUR

## FIG_2

PREMODULATEUR

5

FIG_3